# EUROPÄISCHE PATENTSCHRIFT

(11) **EP 0 837 953 B1**
(45) Veröffentlichungstag und Bekanntmachung des Hinweises auf die Patenterteilung: **24.10.2001**
(21) Anmeldenummer: 96923838.5
(22) Anmeldetag: 10.07.1996
(51) Int. Cl.: C23C 14/16, F16C 33/12, C22C 9/08

(54) **SCHICHTWERKSTOFF**
LAMINATED MATERIAL
MATERIAU STRATIFIE

(30) Priorität: 12.07.1995 DE 19525330
(43) Veröffentlichungstag der Anmeldung: 29.04.1998
(73) Patentinhaber: Federal-Mogul Wiesbaden GmbH & Co.KG, 65201 Wiesbaden (DE)
(72) Erfinder: ANDLER, Gerd, D-60594 Frankfurt am Main (DE)
(86) Internationale Anmeldenummer: DE9601272
(87) Internationale Veröffentlichungsnummer: WO9703219

(56) Entgegenhaltungen:
- EP-A- 0 411 882
- DE-A- 3 629 451
- DE-A- 3 813 801
- DE-A- 4 142 454

## Beschreibung

Die Erfindung betrifft einen Schichtwerkstoff mit einem unmittelbar auf einem Trägerwerkstoff mittels Sputtern aufgebrachten Lagerwerkstoff, der einen Matrixwerkstoff aus Kupfer oder Kupferbasislegierung mit feinverteilten Bleieinlagerungen aufweist.

Werkstoffe auf Kupferbasis mit unterschiedlichen Legierungselementen finden breite Anwendung als hochbelastbare Gleitlagerwerkstoffe in modernen Verbrennungsmotoren. Ihre hohe Festigkeit zeichnet sie für den Einsatz als Pleuellager, Hauptlager, Kolbenbolzen- und Kipphebelbuchsen sowie für den Einsatz als Getriebeteile oder als Bauteile im allgemeinen Maschinenbau aus. Mit zunehmendem Bleigehalt und z.B. abnehmendem Zinngehalt nimmt die Anpassungsfähigkeit und Verträglichkeit mit dem Gegenläufer zu, wobei aber die Korrosionsbeständigkeit und Festigkeit deutlich abnimmt. Für den Einsatz als Pleuel- oder Hauptlager im modernen Motorenbau werden diese Lager deshalb meist mit einer, die Korrosionsbeständigkeit deutlich steigernden galvanischen Drittschicht versehen. So gestaltete Pleuellager- bzw. Kurbelwellenlager finden millionenfach Anwendung im Motorenbau. Der Dreischichtaufbau dieser Schichtwerkstoffe ist jedoch verfahrenstechnisch äußerst aufwendig.

Aus Gleitlager, E. Schmidt, R. Weber, 1953, S. 192 ist es bekannt, daß eine eindeutige Korrelation zwischen der Gefügeausbildung bzw. Gefügegestalt und dem Korrosionsverhalten bei Bleibronzen besteht. Dies bedeutet, daß je feinkristalliner das Gefüge ist und damit auch je feiner die Bleiteilchen innerhalb der Matrix verteilt sind, der Werkstoff umso korrosionsbeständiger ist. Daneben wirkt sich eine möglichst feine globulistische Struktur der Bleiteilchen vorteilhaft aus.

Um dem Verlust an Festigkeit der Matrix mit zunehmendem Bleigehalt wirksam zu begegnen, wird eine möglichst feinkristalline Struktur angetrebt, deren Realisierung aber z.B. auf gießtechnischem Wege nach unten Grenzen gesetzt sind. Die weitaus günstigeren Festigkeitswerte bei feinkristallinen metallischen Werkstoffen verglichen mit grobkristallinen basieren auf einem die Festigkeit deutlich steigernden Effekt, der sich durch folgenden, in Physikalische Metallkunde, Peter Haasen, 2. Auflage 1984, S. 246, beschriebenen Hintergrund verstehen läßt:

In metallischen Werkstoffen wird eine Verformung durch das Wandern von Gitterfehlern (Versetzungen) getragen. Liegt nun ein solcher Werkstoff mit möglichst feinkristallinem Gefügeaufbau, d.h. hohem Korngrenzenanteil, vor, kommt es bei einer Verformung und dem damit verbundenen Wandern von Versetzungen zu einem Aufstau dieser an den Korngrenzen, die als Hindernisse wirken. Hierdurch werden hohe innere Spannungsfelder induziert, die ein weiteres Wandern der Versetzungen verhindern oder zumindest erschweren. Dieser Sachverhalt führt zu einer direkten Korrelation zwischen Korngröße und Festigkeit bei metallischen Werkstoffen über die Hall-Petch-Beziehung, wobei diese sogenannte Korngrenzenverfestigung mit sinkendem Korndurchmesser d gemäß d^{-0.5} zunimmt.

Diese Anforderungen an die Struktur bei der Herstellung von Gleitwerkstoffen lassen sich durch die Anwendung der PVD-Technologie (Sputtern) zur Abscheidung dieser Werkstoffgruppe hervorragend realisieren.

Aus der DE 28 53 724 ist es bekannt, daß mittels Kathodenzerstäubung von Metallen, insbesondere AlSnCu-Legierungen, Gleitschichten hergestellt werden können, die sich gegenüber Gußwerkstoffen gleicher chemischer Zusammensetzung durch weitaus höhere Härten und einem damit verbundenen hervorragenden Verschleißwiderstand auszeichnen. Diese höhere Festigkeit wird durch in der Schicht fein verteilte harte Oxidteilchen bewirkt, was zu einer Dispersionsverfestigung führt, die besonders bei höheren Temperaturen gewährleistet, daß die mechanischen Kennwerte, wie Warmfestigkeit und Warmverschleißfestigkeit, nicht deutlich absinken, wie es von Gußlegierungen bekannt ist. Bei diesem bekannten Schichtwerkstoff, bei dem vorzugsweise AlSn₂₀Cu₁ auf eine Bronzeschicht, z.B. aus CuPb₂₂Sn, aufgesputtert wird, ist eine Diffusionssperrschicht erforderlich. Es werden hier Diffusionssperrschichten aus Chrom/Nickel-Legierungen vorgeschlagen, weil diese sich ebenfalls gut sputtern lassen und sich durch eine hervorragende Haftfestigkeit auf dem Träger und hohe Wirksamkeit als Diffusionssperrschicht auszeichnen. Das Vorsehen einer zusätzlichen Diffusionssperrschicht ist jedoch aufwendig. Darüber hinaus besitzen diese bekannten Schichtwerkstoffe zwar eine große Härte, jedoch Defizite bezüglich der Anpassungs- und Einbettfähigkeit aufweist.

Um auf diese Nickel-Chrom-Zwischenschichten verzichten zu können, wurde gemäß der EP 03 00 993 vorgeschlagen, die Sputterschicht derart auszubilden, daß das Matrixmaterial ein ausgeprägtes Stengelwachstum zeigt, in deren Zwischenräume die Weichphasen feindispers verteilt eingelagert sind. Durch dieses Stengelwachstum, das über die Prozeßparameter eingestellt wird, sollte auch die Abriebfestigkeit verbessert werden. Es hat sich jedoch als nachteilig herausgestellt, daß die stengelförmigen Kristallite relativ groß sind, so daß kein hoher Anteil an Korngrenzen erzielt werden konnte, wodurch die Festigkeit sich als nicht ausreichend herausgestellt hat. Darüber hinaus ist die Einbettfähigkeit der Lagerwerkstoffe nicht zufriedenstellend.

Die DE 3629451 A1 offenbart einen Verbundwerkstoff, der in der Matrix einen unlöslichen Werkstoff mit einem bestimmten Partikeldurchmesser aufweist, dessen Mittelwert x < 0,8 *µ*m sein soll. Die Normalverteilung mit dem Mittelwert x wird offensichtlich dadurch erhalten, daß der Gleitschicht in gezielter Weise spezielle Eigenschaften verliehen werden, die darin bestehen, daß die Temperatur des Substrates während der Beschichtung unter 150°C liegt. Ferner soll hierzu auch eine erhöhte Beschichtungsgeschwindigkeit beitragen. Diese Verfahrensmerkmale sind allesamt auf die Partikelgröße der Bleiteilchen und nicht auf die Kristallstruktur der Matrixteilchen abgestimmt, über die keine näheren Angaben gemacht werden. Die Struktur der erhaltenen Gleitschicht gewährleistet eine Erhaltung der Härte auch nach einer 300 Stunden währenden Wärmebehandlung.

Die DE 4142454 A1 beschreibt keine gesputterten Gleitschichten sondern empfiehlt, für bleihaltige Materialien das Plasmabogenauftragsschweißen einzusetzen. Bei diesem Verfahren ist die Temperaturbelastung höher als beim Sputtern, und es werden weitaus dickere Schichten hergestellt, die ferner noch bearbeitet werden müssen. Die nach diesem Verfahren hergestellten Gleitschichten enthalten 5 bis 40 Gew.-% Blei, wobei die Bleiteilchen einen Durchmesser von bis zu 50 *µ*m aufweisen.

Die DE 3721008 A1 beschreibt einen Schichtwerkstoff, in dem gezielt Hartteilchen eingelagert sind, und die DE 3813801A1 befaßt sich mit einem Schichtwerkstoff mit einer auf einer Trägerschicht angebrachten Funktionsschicht, die eine dünne durchgehend geschlossene Oberflächenregion aufweist, in der die Dispersion durch Schmelzen und rasches Abkühlen aus dem geschmolzenen Zustand eine gegenüber dem übrigen Teil der Funktionsschicht verfeinerte Struktur mit feinteiliger Verteilung der nicht gelösten Bestandteile aufweist. Die Funktionsschicht weist ansich eine grobe Struktur auf, so daß durch zusätzliche Maßnahmen lediglich in einem Oberflächenbereich eine Strukturveränderung durchgeführt werden muß.

Die Aufgabe der Erfindung besteht darin, einen Schichtwerkstoff bereitzustellen, dessen Laufschicht sich durch große Härte und gleichzeitig gute Einbett- und Anpassungsfähigkeit sowie hohe Korrosionsbeständigkeit auszeichnet.

Diese Aufgabe wird mit einem Schichtwerkstoff gelöst, dessen Matrixwerkstoff isotrop mit polygonaler Korngestalt kristallisiert ist, wobei der mittlere Kristallitdurchmesser 2-4 *µ*m und die Korngröße der Bleiablagerungen zwischen den Kristalliten das 0,2 - 0,4-fache des Kristallitdurchmessers beträgt.

Es hat sich gezeigt, daß mit solchen CuPb-Systemen Härten erzielt werden können, die zwischen 120 und 300 HV liegen. Schichten solch hoher Härten werden in der Literatur über Gleitlager normalerweise als viel zu hart angesehen, da sie jegliches Anpassungs- und Einbettvermögen, was als typische Gleitlagerlegierungseigenschaft angesehen wird, vermissen lassen. Es hat sich jedoch gezeigt, daß die erfindungsgemäßen Schichten sehr wohl als hochbelastbare Gleitlager geeignet sind, weil als Folge des hohen Bleianteils und der Unlöslichkeit von Blei in der Kupfer-Sputter-Matrix es während der Einlaufphase im Betrieb eines solchen Gleitlagers sehr schnell zu einer deutlichen Oberflächenanreicherung mit Blei kommt. Dies führt sogar so weit, daß sich auf der Oberfläche eine festhaftende Schicht aus fast reinem Blei ausbildet, die für ein sehr gutes Einlaufverhalten sorgt. Weiterhin hat sich gezeigt, daß als Folge des sehr feinkörnigen Gefüges und dem damit verbundenen großen Korngrenzenanteil jederzeit Blei aus dem Inneren der Kupfer-Blei-Zinn-Matrix an die Oberfläche nachdiffundieren kann, d.h., wird z.B. durch äußere Einflüsse die bleireiche Schicht gestört oder abgetragen, und es kommt es relativ schnell zur Regeneration dieser Laufschicht. Die Beweglichkeit der Bleieinlagerungen hängt offensichtlich weniger von der absoluten Größe der Bleieinlagerungen als vielmehr von dem Matrixgefüge ab, dessen feinkristalline Verteilung und Kristallitgröße auf die Größe der Bleieinlagerungen abgestimmt sein muß. Außerdem gewährleistet die sehr feine Bleiverteilung eine für hoch bleihaltige Lagerlegierungen ausgezeichnete Korrosionsbeständigkeit.

Vorteilhafterweise weisen die Bleieinlagerungen einen mittleren Korndurchmesser zwischen 0,4 *µ* - 1,6 *µ*m auf. Die obere Grenze des mittleren Korndurchmessers liegt somit eine Größenordnung unterhalb der Korndurchmesser, die auf gießtechnischem Wege hergestellt werden können. Zu kleine Korndurchmesser, d.h. Korndurchmesser unter 0,6 *µ*m können zwar ebenfalls verwendet werden, hierbei ist es jedoch schwierig, den Kristallitdurchmesser des Matrixmaterials entsprechend klein einzustellen, damit das erfindungsgemäße Verhältnis von Kristallitdurchmesser zu Korndurchmesser eingehalten werden kann. Vorzugsweise liegt der Bleianteil bei 15 - 45 Gew.-%, wobei höhere Bleianteile von 30 - 45 Gew.-% bevorzugt sind, um eine ausreichend dicke bleireiche Schicht auf der Oberfläche des Lagerwerkstoffes zu erzielen.

Der Matrixwerkstoff kann noch weitere Zusätze einzeln oder in Kombination enthalten. Hierzu zählen insbesondere Zinn, Nickel, Aluminium und Zink. Die Anteile dieser Komponenten liegen vorzugsweise bei 0 - 10 Gew.-% für Zinn, bei 2 - 8 Gew.-% für Nickel, bei 5 - 25 Gew.-% bei Zink und bei 2-10 Gew.-% für Aluminium.

Die Gesamtdicke der Laufschicht des Lagerwerkstoffes beträgt vorzugsweise 16 - 18 *µ*m. Für besondere Anwendungsfälle kann der Lagerwerkstoff mit einer galvanisch aufgebrachten Ternärschicht oder mit einem Flash versehen sein. Eine solche Ternärschicht kann aus den an sich bekannten Systemen PbSnCu oder SnSbCu bestehen. Sie wird vorzugsweise dann auf den gesputterten Lagerwerkstoff aufgebracht, wenn der Schichtwerkstoff für Anwendungsfälle mit besonders kritischer Einlaufphase vorgesehen ist und dient dazu, die Zeit bis zu der endgültigen Ausbildung der bleireichen Oberflächenschicht zu überbrücken. Die Dicke der Tenärschicht beträgt vorzugsweise 3 - 8 *µ*m und die Dicke des Flashs 1 - 3 *µ*m. Die Dicke des gesputterten Lagerwerkstoffes wird in diesem Fall auf 10 - 13 *µ*m reduziert, um die angestrebte Gesamtdicke von 16 - 18 *µ*m nicht zu überschreiten.

Als Trägerwerkstoff kann ein Stahlstützmetall verwendet werden, auf das der Lagerwerkstoff ohne weitere Zwischenschicht aufgebracht werden kann. Es besteht aber auch die Möglichkeit, als Trägerwerkstoff einen kupferhaltigen, insbesondere einen Trägerwerkstoff aus einer Kupfer-Blei-Zinn-Legierung zu verwenden. Beispielsweise kann der Trägerwerkstoff aus CuPb₂₂Sn bestehen.

Wenn der Bleianteil des Trägerwerkstoffes in der Größenordnung des Bleianteils des Lagerwerkstoffes liegt, besteht zwischen beiden Materialien kein oder nur ein geringes Konzentrationsgefälle, so daß auch keine Diffusionsvorgänge zwischen dem Lagerwerkstoff und dem Trägerwerkstoff stattfinden können. Wenn der Trägerwerkstoff eine höhere Bleikonzentration als der Lagerwerkstoff aufweist, wird die Abwanderung des Bleis an die Oberfläche des Lagerwerkstoffes zusätzlich begünstigt. Die Kupfer-Blei-Zinn-Legierung, die den Trägerwerkstoff bildet, kann auf ein Stahlstützmetall gießplattiert sein.

Der erfindungsgemäße Schichtwerkstoff zeichnet sich dadurch aus, daß das Material des Trägerwerkstoffes, also z.B. die gießplattierte CuPbSn-Schicht, weicher ist als das Gleitmaterial, wobei die Gleitmaterialschicht an ihrer Oberfläche in einem bestimmten Bereich durch die sich ausbildende Pb-reiche Zone wiederum weicher ist als das Gleitmaterial. Ein Schichtaufbau, mit derartigen Härteabstufungen weist eine große Verschleißbeständigkeit, Korrosionsbeständigkeit sowie eine hervorragende Einbett- und Anpassungsfähigkeit auf.

Beispielhafte Ausführungsformen der Erfindung werden nachfolgend anhand der Zeichnungen näher erläutert.

Es zeigen:
- Figur 1: einen Schichtwerkstoff im Schnitt,
- Figur 2: die in Figur 1 gezeigte Sputterschicht in vergrößerter Darstellung,
- Figur 3: die Sputterschicht in vergrößerter Darstellung nach der Einlaufphase und
- Figur 4a-d: eine rastermikroskopische Oberflächenaufnahme nach einem Laufversuch, vor (a) und nach Entfernen (b) der Pb-reichen Schicht, sowie die dazugehörigen Röntgenspektren (c, d).

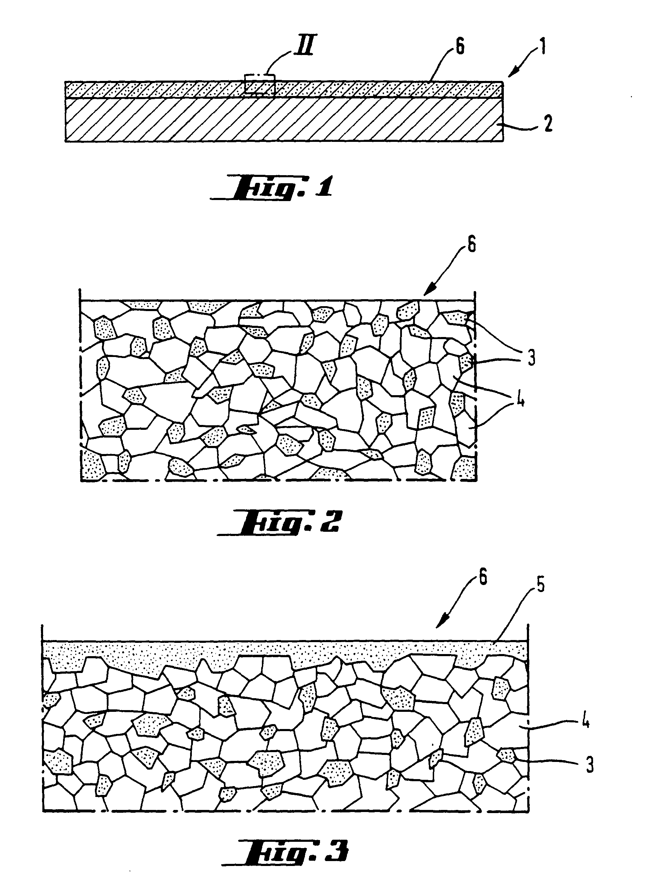

In der Figur 1 ist der Schichtwerkstoff 1 im Schnitt dargestellt, der aus einem Trägerwerkstoff 2 besteht, auf dem der Lagerwerkstoff als Gleitschicht 6 aufgesputtert ist. Es handelt sich hierbei um eine Kupfer-Blei-Legierung, die in der Figur 2 vergrößert dargestellt ist. Das Matrixmaterial 4, das in dem hier gezeigten Beispiel aus Kupfer besteht, ist isotrop mit polygonaler Korngestalt kristallisiert, d.h. es gibt keine Vorzugsrichtung oder gar ein Stengelwachstum. An den Korngrenzen sind Bleiteilchen 3 eingelagert, deren Korngrößen im Bereich des 0,2 - 0,4 *µ*m-fachen der Matrixkristalle liegen.

Der in den Figuren 1 und 2 dargestellte Schichtwerkstoff wurde wie folgt hergestellt:

Lagerschalen des Aufbaues Stahl/CuPb22Sn werden auf einem Träger in einer konventionellen Kathodenzerstäubungsanlage gegenüber einem Target, das die Zusammensetzung der resultierenden Gleitschicht (z.B. CuPb30Sn) hat, plaziert. Nach dem Evakuieren der Sputteranlage bis auf etwa 10-4 mbar und dem Fluten des Rezipienten mit Argon wird durch Umkehrung des normalen Sputterprozesses die Oberfläche der Lagerschalen freigesputtert.

Bei einem Druck von etwa 3,5 x 10-2 mbar und einer in das Target eingebrachten Leistungsdichte 13 W/cm² konnte anschließend eine Schicht der Zusammensetzung CuPb28Sn abgeschieden werden. Für den angestrebten Gefügeaufbau der Sputterschicht haben sich hierbei Beschichtungstemperaturen von > 175°C als Optimum herauskristallisiert. Die mit diesen Eckwerten erreichte Abscheidungsrate für das System CuPbSn liegt (je nach in das Traget eingebrachter Leistung) zwischen 0,45 und 0,5 *µ*m/min.

So hergestellte Gleitschichten haben eine Härte von 170-190 HV.

In der Figur 3 ist ein Schnitt durch die in Figur 2 gezeigte Sputterschicht 6 nach der Einlaufphase dargestellt. Unter Einlaufphase wird die Phase verstanden, bis sich Gleitlager und Gegenläufer in ihrer Oberflächenstruktur aneinander angepaßt haben. Aufgrund der Wärmeentwicklung wandert das Blei über die Korngrenzen des Matrixwerkstoffes 4 an die Oberfläche und bildet dort eine weiche Deckschicht 5, die 1 - 3 *µ*m dick ist.

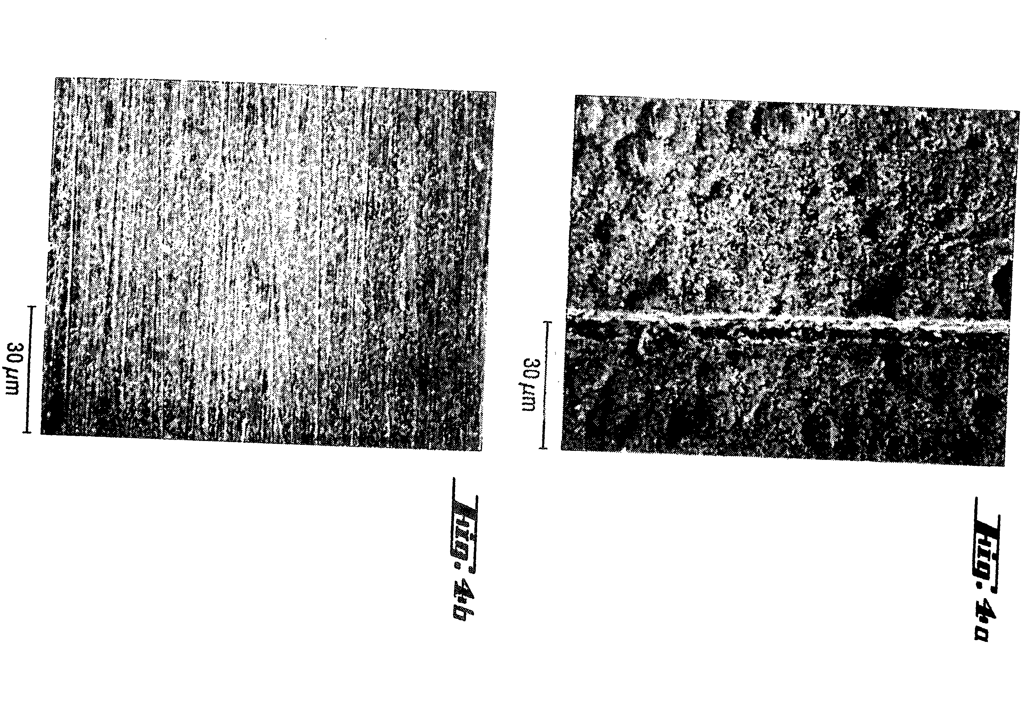

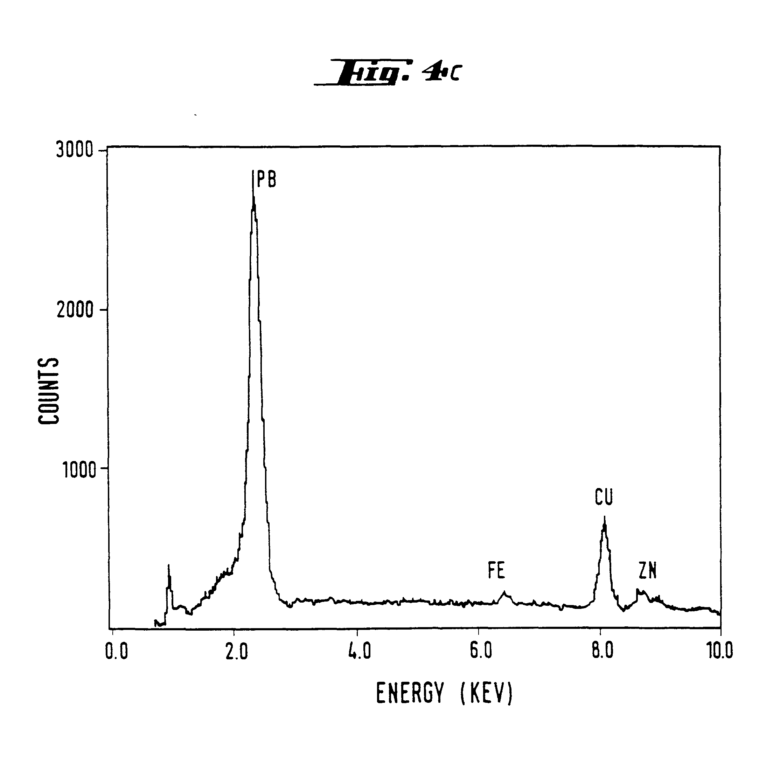

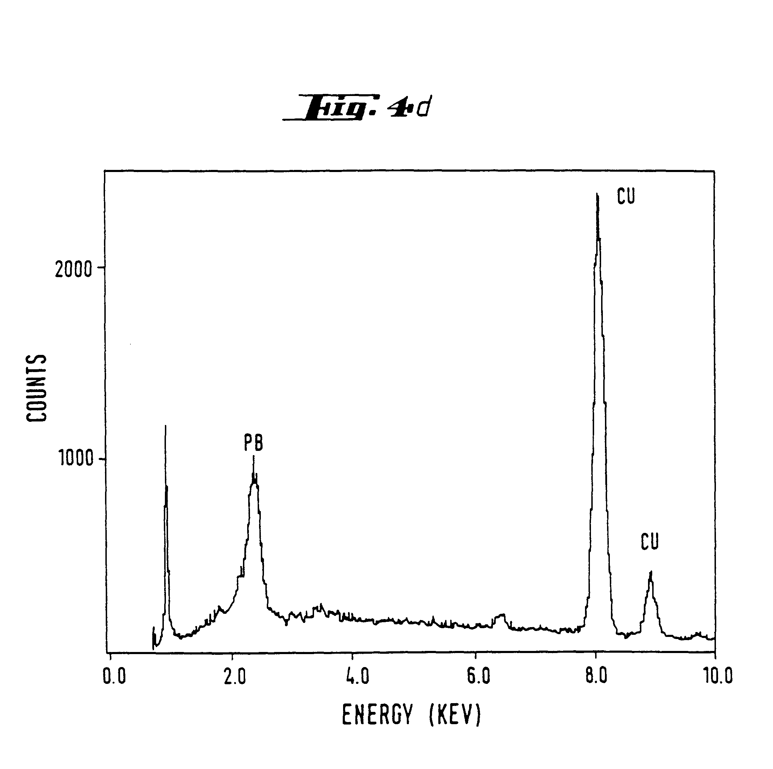

Figur 4a zeigt eine Oberflächenaufnahme einer gelaufenen Lagerschale. Deutlich erkennbar ist das gute Anpassungsverhalten der Sputterschicht, was sich in der Riefenausbildung, verursacht durch Schmutzpartikel im Öl wiederspiegelt.

Figur 4b zeigt ebenfalls eine Oberflächenaufnahme der gleichen Lagerschale jedoch nach Entfernen der Pb-reichen Deckschicht. Die dazugehörigen Röntgenspektren belegen den hohen Pb-Gehalt der Deckschicht (Figur 4c), der sich während der Einlaufpahse ausbildet und verantwortlich ist für das erwähnte gute Anpassungsvermögen der Laufschicht. Nach Entfernen der Pb-reichen Schicht ist in Figur 4d die Zusammensetzung der darunterliegenden Bereiche dargestellt.

### Bezugszeichenliste

- 1: Schichtwerkstoff
- 2: Trägerwerkstoff
- 3: Bleiteilchen
- 4: Matrixwerkstoff
- 5: Deckschicht
- 6: Gleitschicht

## Patentansprüche

1. Schichtwerkstoff mit einem unmittelbar auf einem Trägerwerkstoff mittels Sputtern aufgebrachten Lagerwerkstoff, der einen Matrixwerkstoff aus Kupfer oder Kupferbasislegierung mit fein verteilten Bleieinlagerungen aufweist, **dadurch gekennzeichnet,**
**daß** der Matrixwerkstoff (4) isotrop mit polygonaler Korngestalt kristallisiert ist, wobei der mittlere Kristallitdurchmesser 2-4 *µ*m und die Korngröße der Bleieinlagerungen (3) das 0,2 - 0,4-fache des Kristallitdurchmessers beträgt.

2. Schichtwerkstoff nach Anspruch 1, **dadurch gekennzeichnet, daß** die Bleieinlagerungen (3) einen mittleren Korndurchmesser zwischen 0,4 *µ*m und 1,6 *µ*m aufweisen.

3. Schichtwerkstoff nach Anspruch 1 oder 2, **dadurch gekennzeichnet, daß** der Bleianteil 15 bis 45 Gew.-% beträgt.

4. Schichtwerkstoff nach Anspruch 3, **dadurch gekennzeichnet, daß** der Bleianteil 30 bis 45 Gew.-% beträgt.

5. Schichtwerkstoff nach einem der Ansprüche 1 bis 4, **dadurch gekennzeichnet, daß** der Matrixwerkstoff (4) folgende Zusätze einzeln oder in Kombination enthält: Zinn, Nickel, Aluminium, Zink.

6. Schichtwerkstoff nach Anspruch 5, **dadurch gekennzeichnet, daß** die Zusätze in folgenden Anteilen im Matrixwerkstoff (4) enthalten sind: Zinn 0 bis 10 Gew.-%, Nickel 2 bis 8 Gew.-%, Zink 5 bis 25 Gew.-%, Aluminium 2 bis 10 Gew.-%.

7. Schichtwerkstoff nach einem der Ansprüche 1 bis 6, **dadurch gekennzeichnet, daß** der Lagerwerkstoff mit einer galvanisch aufgebrachten Ternärschicht oder mit einem Flash versehen ist.

8. Schichtwerkstoff nach Anspruch 7, **dadurch gekennzeichnet, daß** die Dicke der Ternärschicht 3 bis 8 *µ*m und die Dicke des Flash 1 bis 3 *µ*m beträgt.

9. Schichtwerkstoff nach einem der Ansprüche 7 oder 8, **dadurch gekennzeichnet, daß** die Dicke des Lagerwerkstoffes 10 bis 13 *µ*m beträgt.

10. Schichtwerkstoff nach einem der Ansprüche 1 bis 9, **dadurch gekennzeichnet, daß** die Gesamtdicke der Laufschicht aus Lagerwerkstoff und Ternärschicht oder Flash 16 bis 18 *µ*m beträgt.

11. Schichtwerkstoff nach einem der Ansprüche 1 bis 10, **dadurch gekennzeichnet, daß** der Trägerwerkstoff Kupfer enthält.

12. Schichtwerkstoff nach Anspruch 11, **dadurch gekennzeichnet, daß** der Trägerwerkstoff eine Kupfer-Blei-Zinnlegierung ist.

13. Schichtwerkstoff nach einem der Ansprüche 11 oder 12, **dadurch gekennzeichnet, daß** die Kupfer-Blei-Zinnlegierung auf ein Stahlstützmetall gießplattiert ist.

14. Schichtwerkstoff nach einem der Ansprüche 1 bis 10, **dadurch gekennzeichnet, daß** der Trägerwerkstoff ein Stahlstützmetall ist.

## Claims

1. A laminate material comprising a bearing material which is applied directly to a carrier material by means of sputtering and which has a matrix material of copper or copper-based alloy with finely distributed lead inclusions, **characterised in that**
the matrix material (4) is isotropically crystallised with a polygonal grain shape, wherein the mean crystallite diameter is 2 - 4 µm and the grain size of the lead inclusions (3) is 0.2 - 0.4 times the crystallite diameter.

2. A laminate material according to claim 1 **characterised in that** the lead inclusions (3) are of a mean grain diameter of between 0.4 µm and 1.6 µm.

3. A laminate material according to claim 1 or claim 2 **characterised in that** the proportion of lead is from 15 to 45 % by weight.

4. A laminate material according to claim 3 **characterised in that** the proportion of lead is from 30 to 45 % by weight.

5. A laminate material according to one of claims 1 to 4 **characterised in that** the matrix material (4) contains the following additions individually or in combination: tin, nickel, aluminium and zinc.

6. A laminate material according to claim 5 **characterised in that** the additions are contained in the matrix material (4) in the following proportions: lead from 0 to 10 % by weight, nickel from 2 to 8 % by weight, zinc from 5 to 25 % by weight and aluminium from 2 to 10 % by weight.

7. A laminate material according to one of claims 1 to 6 **characterised in that** the bearing material is provided with a ternary layer applied by electroplating or with a flash.

8. A laminate material according to claim 7 **characterised in that** the thickness of the ternary layer is from 3 to 8 µm and the thickness of the flash is from 1 to 3 µm.

9. A laminate material according to one of claims 7 and 8 **characterised in that** the thickness of the bearing material is from 10 to 13 µm.

10. A laminate material according to one of claims 1 to 9 **characterised in that** the total thickness of the running layer comprising bearing material and ternary layer or flash is from 16 to 18 µm.

11. A laminate material according to one of claims 1 to 10 **characterised in that** the carrier material contains copper.

12. A laminate material according to claim 11 **characterised in that** the carrier material is a copper-lead-tin alloy.

13. A laminate material according to one of claims 11 and 12 **characterised in that** the copper-lead-tin alloy is plated onto a steel backing metal by a casting procedure.

14. A laminate material according to one of claims 1 to 10 **characterised in that** the carrier material is a steel backing metal.

## Revendications

1. Matériau stratifié présentant un matériau pour palier appliqué directement sur un matériau de support au moyen d'une pulvérisation cathodique, lequel présente un matériau de matrice en cuivre ou dans un alliage à base de cuivre présentant des incursions de plomb finement dispersées, **caractérisé en ce que**
le matériau de matrice (4) est cristallisé de façon isotrope avec une forme de grain polygonale, le diamètre moyen des cristallites étant compris entre 2 et 4 µm et la granularité des incursions de plomb (3) représentant 0,2 à 0,4 fois le diamètre des cristallites.

2. Matériau stratifié selon la revendication 1, **caractérisé en ce que** les incursions de plomb (3) présentent un diamètre de grain moyen compris entre 0,4 µm et 1,6 µm.

3. Matériau stratifié selon la revendication 1 ou 2, **caractérisé en ce que** la teneur en plomb est comprise entre 15 et 45 % en masse.

4. Matériau stratifié selon la revendication 3, **caractérisé en ce que** la teneur en plomb est comprise entre 30 et 45 % en masse.

5. Matériau stratifié selon l'une des revendications 1 à 4, **caractérisé en ce que** le matériau de matrice (4) contient, séparément ou en combinaison, les différents additifs suivants : étain, nickel, aluminium, zinc.

6. Matériau stratifié selon la revendication 5, **caractérisé en ce que** les additifs sont contenus dans le matériau de matrice (4) dans les proportions suivantes : 0 à 10 % en masse d'étain, 2 à 8 % en masse de nickel, 5 à 25 % en masse de zinc et 2 à 10 % en masse d'aluminium.

7. Matériau stratifié selon l'une des revendications 1 à 6, **caractérisé en ce que** le matériau pour palier est pourvu d'un flash ou d'une couche ternaire appliquée par procédé électrolytique.

8. Matériau stratifié selon la revendication 7, **caractérisé en ce que** l'épaisseur de la couche ternaire est comprise entre 3 et 8 µm et l'épaisseur du flash entre 1 et 3 µm.

9. Matériau stratifié selon l'une des revendications 7 ou 8, **caractérisé en ce que** l'épaisseur du matériau pour palier est comprise entre 10 et 13 µm.

10. Matériau stratifié selon l'une des revendications 1 à 9, **caractérisé en ce que** l'épaisseur totale de la couche antifriction composée du matériau pour palier et de la couche ternaire ou du flash est comprise entre 16 et 18 µm.

11. Matériau stratifié selon l'une des revendications 1 à 10, **caractérisé en ce que** le matériau de support contient du cuivre.

12. Matériau stratifié selon la revendication 11, **caractérisé en ce que** le matériau de support est un alliage de cuivre-plomb-étain.

13. Matériau stratifié selon l'une des revendications 11 ou 12, **caractérisé en ce que** l'alliage cuivre-plomb-étain est appliqué par coulée sur un métal d'appui en acier.

14. Matériau stratifié selon l'une des revendications 1 à 10, **caractérisé en ce que** le matériau de support est un métal d'appui en acier.
